(19) **Europäisches Patentamt / European Patent Office / Office européen des brevets**

(11) **EP 4 697 014 A1**

(12) # EUROPEAN PATENT APPLICATION
published in accordance with Art. 153(4) EPC

(43) Date of publication:
**18.02.2026 Bulletin 2026/08**

(21) Application number: **24788441.4**

(22) Date of filing: **28.02.2024**

(51) International Patent Classification (IPC):
**G01N 21/956** (2006.01)  **G01N 21/88** (2006.01)
**H01L 21/66** (2006.01)

(52) Cooperative Patent Classification (CPC):
**G01N 21/64; G01N 21/88; G01N 21/956;
H10P 74/00**

(86) International application number:
**PCT/JP2024/007268**

(87) International publication number:
**WO 2024/214411 (17.10.2024 Gazette 2024/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **10.04.2023 JP 2023063355**

(71) Applicant: **Kware Systems Co., Ltd.
Kawasaki-shi, Kanagawa 212-0025 (JP)**

(72) Inventor: **KIMURA, Kazuhiko
Kawasaki-shi, Kanagawa 212-0025 (JP)**

(74) Representative: **Strehl & Partner mbB
Maximilianstrasse 54
80538 München (DE)**

(54) **INSPECTION DEVICE**

(57)    An object is to obtain a highly accurate reflection image or the like. An inspection device includes: a surface defect detection system including an illumination device including an illumination laser light source device and a reflection observation device including a reflection sensor; and a photoluminescence detection system including a UV irradiation device including an excitation laser light source device and a fluorescence observation device including a fluorescence sensor, in which measurement light is acquired by the reflection observation device and fluorescence is acquired by the fluorescence observation device while irradiating an object with illumination light by the illumination laser light source device and irradiating the object with excitation light by the excitation laser light source device through a common optical path.

Fig. 1

EP 4 697 014 A1

# Description

## Technical Field

The present invention relates to an inspection device that detects a defect which is present in a compound semiconductor substrate represented by a silicon carbide substrate or other semiconductor substrates.

## Background Art

In a semiconductor device production process using a SiC substrate or the like, it is important to detect defects present in the SiC substrate in order to improve a production yield. It is known that an illumination beam is projected toward a SiC substrate, reflected light and photoluminescence light emitted from the SiC substrate are separately detected, a reflection image and a photoluminescence image are formed, a defect image is detected from the reflection image and the photoluminescence image, and a defect is classified (Patent Literatures 1 and 2).

In the devices of Patent Literatures 1 and 2, a reflection image and a photoluminescence image are obtained from a single-wavelength illumination beam, and a sensor or an imaging optical system for obtaining a reflection image cannot be freely selected or configured, and it is not easy to obtain a highly accurate reflection image.

In the devices of Patent Literatures 1 and 2, a reflection image and a photoluminescence image are obtained from a single-wavelength ultraviolet illumination beam transmitted through a slit, but since an intensity of light transmitted through a narrow slit is weak, it is difficult to generate a sufficient quantity of fluorescence necessary for detection, and it is not easy to obtain a highly accurate reflection image. In addition, in a case where a wavelength of the illumination light for reflection measurement is ultraviolet light, since a quantum efficiency of an image sensor in an ultraviolet region is low and a light receiving sensitivity is low, it is not easy to obtain a reflection image having an excellent S/N ratio in this respect.

## Citation List

## Patent Literature

Patent Literature 1: JP5633099B
Patent Literature 2: JP5713419B

## Summary of Invention

The present invention has been made in view of the background art, and an object thereof is to obtain a highly accurate reflection image or the like at high speed.

In order to achieve the above object, an inspection device according to the present invention includes: a surface defect detection system including an illumination device including an illumination laser light source device and a reflection observation device including a reflection sensor; and a photoluminescence detection system including a UV irradiation device including an excitation laser light source device and a fluorescence observation device including a fluorescence sensor, in which measurement light is acquired by the reflection observation device and fluorescence is acquired by the fluorescence observation device while irradiating an object with illumination light by the illumination laser light source device and irradiating the object with excitation light by the excitation laser light source device.

In the inspection device, since the illumination laser light source device and the excitation laser light source device are separately prepared, a sensor or an optical system for obtaining a reflection image can be freely selected, and a sufficient quantity of light can be secured without using a light source such as a lamp that needs to be transmitted through a slit, so that the defect detection system can be made highly accurate.

In a specific aspect of the present invention, the inspection device includes a common optical path-type optical system configured to perform irradiation with the illumination light by the illumination laser light source device and irradiation with the excitation light by the excitation laser light source device in parallel. In this case, the directly reflected measurement light and the fluorescence due to excitation can be simultaneously measured, and an inspection speed can be improved.

In another aspect of the present invention, in the surface defect detection system, the illumination device and the reflection observation device are configured as a confocal optical system. In this case, since only reflected light from a substrate surface can be selectively detected, only a defect on the substrate surface can be separately inspected.

In still another aspect of the present invention, the surface defect detection system is a multi-beam optical system and composites images obtained by a plurality of line sensors.

In still another aspect of the present invention, the inspection device further includes an oblique incidence device including an oblique incidence light source device, a dark-field observation device including a dark-field sensor, and a surface roughness detection system, in which the oblique incidence device and the surface roughness detection system serve as elements constituting the common optical path-type optical system together with the surface defect detection system and the photoluminescence detection system.

In still another aspect of the present invention, the illumination device, the reflection observation device, the UV irradiation device, the fluorescence observation device, the oblique incidence device, and the dark-field observation device have a common objective lens as an element of the common optical path-type optical system. Since the surface defect detection system, the photoluminescence detection system, and the surface roughness detection system have a common objective lens, the autofocus system can be easily shared among the surface defect detection system, the photoluminescence detection system, and the surface roughness detection system, and the measurement can be performed with high accuracy.

In still another aspect of the present invention, the photoluminescence detection system illuminates the object with excitation light of a plurality of wavelengths. In this case, since a penetration depth of the excitation light into a substrate depends on the wavelength, it is possible to inspect defects having different depths.

In still another aspect of the present invention, the photoluminescence detection system measures fluorescence from the object in a plurality of wavelength regions including a near ultraviolet wavelength region and a long wavelength region having a longer wavelength than the near ultraviolet wavelength region.

Brief Description of Drawings

Fig. 1 is a block diagram illustrating an overall configuration of an inspection device according to an embodiment.
Fig. 2A illustrates coordinate axes on a stage.
Fig. 2B illustrates relative movement of an objective lens and the like with respect to a workpiece.
Fig. 3 illustrates an example of an image acquisition method using multiple beams.
Fig. 4A illustrates other example of the image acquisition method using multiple beams.
Fig. 4B illustrates other example of the image acquisition method using multiple beams.
Fig. 5A is a diagram illustrating a method of avoiding malfunction of an AF operation by an autofocus system due to a stray light component during surface inspection by a surface defect detection system.
Fig. 5B is a diagram illustrating a method of avoiding malfunction of an AF operation by an autofocus system due to a stray light component during surface inspection by a surface defect detection system.
Fig. 5C is a diagram illustrating a method of avoiding malfunction of an AF operation by an autofocus system due to a stray light component during surface inspection by a surface defect detection system.
Fig. 6 illustrates a defect review operation.

Description of Embodiments

Hereinafter, an inspection device and an operation thereof according to an embodiment of the present invention will be described with reference to the drawings.

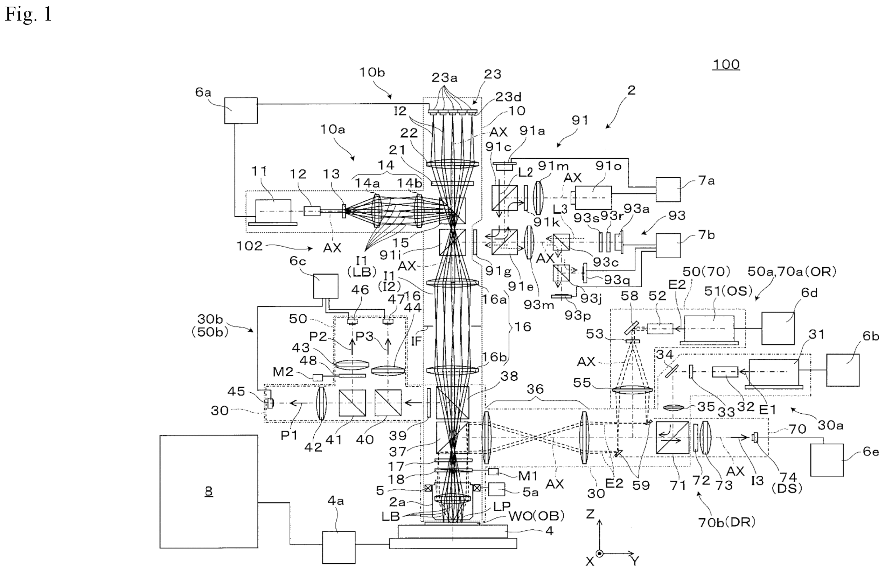

Referring to Fig. 1, an inspection device 100 of the embodiment includes an inspection optical system 2, a stage 4, and a control device 8. A workpiece WO, which is an object OB to be inspected by the inspection device 100, is supported on a stage 4. The workpiece WO is, for example, a SiC wafer. In the figure, XYZ represents an orthogonal coordinate system. In an optical system, a reference sign AX denotes an optical axis.

The inspection optical system 2 includes a vertically incident illumination-type surface defect detection system 10, a vertically incident excitation-type first photoluminescence detection system 30, an obliquely incident excitation-type second photoluminescence detection system 50, an obliquely incident illumination-type surface roughness detection system 70, an area observation system 91, and an autofocus system 93.

The surface defect detection system 10 includes, as an illumination device 10a, an illumination laser light source device 11, a beam expander 12, a diffractive optical element (DOE) 13, a first lens system 14, a polarizing beam splitter (PBS) prism 15, a second lens system 16, a quarter-wave plate 17, a Nomarski prism 18, and an objective lens 2a. Here, the illumination laser light source device 11 outputs laser illumination light I1 with a wavelength of 445 nm in a visible wavelength region, for example. The laser illumination light I1 has, for example, an electric field plane or a polarization plane in an X direction perpendicular to the sheet. The beam expander 12 expands a diameter of a light beam of the laser illumination light I1 by, for example, about five times from 1 mm to 5 mm. The diffractive optical element 13 forms a large number of line beams LB from the laser illumination light I1. The line beams LB are in a collimated state. The large number of line beams LB are also referred to as multiple beams. The first lens system 14 includes a pair of lenses 14a and 14b, and projects a pupil onto an object side of the polarizing beam splitter prism 15. The polarizing beam splitter prism 15 reflects the laser illumination light I1 having a polarization plane in the X direction perpendicular to the sheet. The second lens system 16 includes a pair of lenses 16a and 16b, and projects a pupil between the objective lens 2a and an exit side of the second lens system 16. An intermediate focal position IF is disposed between the pair of lenses 16a and 16b. The quarter-wave plate 17 converts the laser illumination light I1 into circularly polarized light. The Nomarski prism 18 enables differential interference measurement that emphasizes fine irregularities. The objective lens 2a causes the laser illumination light I1 to be incident on the workpiece WO as a large number of separated line beams LB. A multi-line pattern LP corresponding to the large number of line beams LB is projected on a surface of the workpiece WO. Here, the large number of line beams LB are separated from each other in a direction orthogonal to a longitudinal direction, and are projected at equal intervals. In the illumination device 10a, the objective lens 2a serves to cause the laser illumination light I1 as a whole to be vertically incident on the workpiece WO for surface defect inspection.

In the illumination device 10a, the Nomarski prism 18 can be moved back and forth between an operating position on an optical path and a retracted position outside the optical path by a driving device M1, allowing fine adjustment of the arrangement on the optical path. The Nomarski prism 18 separates a polarization component of the laser illumination light I1 into two components such as ordinary light and extraordinary light, and separates both lights in a horizontal X direction to generate a minute horizontal distance (shear). The normal light and the abnormal light are incident on, for example, two points separated from each other in the X direction on the workpiece WO, and measurement light I2 reflected by the workpiece WO passes through the Nomarski prism 18 again, travels backward along the same optical path, and is incident on a multi-line reflection sensor 23 to be described later. When there is a height difference between two points on the workpiece WO on which the ordinary light and the extraordinary light are incident, the ordinary light and the extraordinary light are out of phase with each other and interfere with each other at the time of merging, so that a bright-dark luminance contrast occurs in a portion of the workpiece WO where there is a gradient distribution, and surface irregularities of the workpiece WO are emphasized.

The surface defect detection system 10 includes, as a reflection observation device 10b, the objective lens 2a, the Nomarski prism 18, the quarter-wave plate 17, the second lens system 16, the polarizing beam splitter (PBS) prism 15, a bandpass filter 21, a re-imaging lens 22, and the multi-line reflection sensor 23. Among the above, the objective lens 2a, the Nomarski prism 18, the quarter-wave plate 17, the second lens system 16, and the polarizing beam splitter prism 15 are elements common to the illumination device 10a. The bandpass filter 21 selectively transmits the laser illumination light I1 with a wavelength of 445 nm, and prevents measurement light for AF, which will be described later, from entering the reflection sensor 23. The reflection sensor 23 includes a large number of line sensors 23a arranged at equal intervals in a Y direction. The line sensors 23a each have a detection surface 23d extending in a direction orthogonal to a scanning direction. Each line sensor 23a detects a pattern of a large amount of measurement light I2 corresponding to a large number of line beams LB, that is, a multi-line image. Here, a large number of line patterns constituting the multi-line image are separated from each other in the direction orthogonal to the longitudinal direction, and are imaged at equal intervals.

In the above, the illumination device 10a and the reflection observation device 10b are configured as a confocal optical system, and can have resolution in a depth direction. Since only reflected light from a substrate surface can be selectively detected by configuring the illumination device 10a and the reflection observation device 10b as a confocal optical system, only a defect on the substrate surface can be separately inspected.

The first photoluminescence detection system 30 includes, as a UV irradiation device 30a, an excitation laser light source device 31, a beam expander 32, a diffractive optical element 33, a mirror 34, a light source lens 35, a dichroic mirror 71, a relay lens system 36, a dichroic mirror 37, the quarter-wave plate 17, and the objective lens 2a. Among the above, the objective lens 2a and the quarter-wave plate 17 are elements common to the illumination device 10a or the reflection observation device 10b of the surface defect detection system 10. The excitation laser light source device 31 outputs excitation light E1 in a plurality of ultraviolet wavelength regions such as a wavelength of 266 nm and a wavelength of 325 nm. The diffractive optical element 33 uniformly diffracts the excitation light E1 in a two-dimensional direction. That is, the excitation light E1 passing through the diffractive optical element 33 has a rectangular cross section.

The first photoluminescence detection system 30 includes, as a fluorescence observation device 30b, the objective lens 2a, the quarter-wave plate 17, the dichroic mirror 37, a branching half mirror 38, a notch filter 39, a pair of fluorescence branching dichroic mirrors 40 and 41, imaging lenses 42, 43, and 44, fluorescence sensors 45, 46, and 47, and a bandpass filter 48. Among the above, the objective lens 2a, the quarter-wave plate 17, and the dichroic mirror 37 are elements common to the UV irradiation device 30a. The first fluorescence sensor 45 detects fluorescence P1 in an infrared wavelength region of, for example, 700 nm or more. The second fluorescence sensor 46 detects fluorescence P2 in a visible wavelength region, for example. The third fluorescence sensor 47 detects fluorescence P3 in a near ultraviolet wavelength region of, for example, 380 to 400 nm. The bandpass filter 48 can be moved back and forth between an operating position on the optical path and a retracted position outside the optical path by a driving device M2, and can be replaced with another bandpass filter having a different transmission wavelength. In the above, the fluorescence sensors 45, 46, and 47 each are specifically a time delay integration (TDI) sensor, and respectively measure the fluorescence P1, P2, and P3 with high sensitivity while moving the stage in the Y direction. The TDI sensor has a rectangular detection surface, and the rectangular detection surface is short in the Y direction, which is to be scanned, and has a small number of pixels, and is long in the X direction, which is not scanned, and has a large number of pixels. The TDI sensor performs imaging while moving the workpiece WO in the Y direction by scanning. Since the TDI sensor transfers charges in the Y direction in accordance with a moving speed of the workpiece WO, it is possible to integrate a luminance value, increase an amount of detected light, and increase sensitivity. In addition, since there is a smoothing effect by integrating the luminance values, noise is reduced.

When the workpiece WO is a SiC substrate or a wafer and the workpiece WO is illuminated with the excitation light E1, band-edge emission occurs even if there is no defect. Specifically, the SiC wafer emits fluorescence at a wavelength of 380 to 400 nm. When a defect is present in the SiC wafer, for example, fluorescence is generated at a wavelength of 480 nm, and fluorescence at a wavelength of 380 to 400 nm is reduced. When defects or impurities are present in the SiC wafer, it is also reported that fluorescence is generated at a wavelength of, for example, around 420 nm or 450 nm. Further, when the defects or impurities are present in the SiC wafer, it is also reported that fluorescence is generated in an infrared region.

The second photoluminescence detection system 50 is an obliquely incident optical system, and includes, as a UV irradiation device 50a, a dual-purpose laser light source device 51, a beam expander 52, a mirror 58, a diffractive optical element 53, a light source lens 55, a perforated mirror 59, the relay lens system 36, the dichroic mirror 37, the quarter-wave plate 17, and the objective lens 2a. Among the above, the relay lens system 36, the dichroic mirror 37, the quarter-wave plate 17, and the objective lens 2a are elements common to the first photoluminescence detection system 30. The dual-purpose laser light source device 51 outputs excitation light E2 in, for example, an ultraviolet wavelength region of 355 nm. The diffractive optical element 53 diffracts the excitation light E2 in a direction along a conical surface. That is, the excitation light E2 passing through the diffractive optical element 53 has an annular cross section. By using the excitation light E2 having such an annular cross section, oblique illumination can be performed from all directions, and occurrence of directionality in defect detection can be prevented.

The second photoluminescence detection system 50 includes, as a fluorescence observation device 50b, the objective lens 2a, the quarter-wave plate 17, the dichroic mirror 37, the branching half mirror 38, the notch filter 39, a pair of fluorescence branching dichroic mirrors 40 and 41, the imaging lenses 42, 43, and 44, the fluorescence sensors 45, 46, and 47, and the bandpass filter 48. Among the above, the objective lens 2a, the quarter-wave plate 17, and the dichroic mirror 37 are elements common to the fluorescence observation device 50b or the UV irradiation device 30a.

The surface roughness detection system 70 is an obliquely incident optical system, and includes, as a UV irradiation device 70a, the dual-purpose laser light source device 51, the beam expander 52, the mirror 58, the diffractive optical element 53, the light source lens 55, the perforated mirror 59, the relay lens system 36, the dichroic mirror 37, the quarter-wave plate 17, and the objective lens 2a. The UV irradiation device 70a also functions as the UV irradiation device 50a of the second photoluminescence detection system 50. In the present specification, the UV irradiation device 70a is referred to as an oblique incidence device OR, and the dual-purpose laser light source device 51 is referred to as an oblique incidence light source device OS.

The surface roughness detection system 70 includes, as an observation device 70b, the objective lens 2a, the quarter-wave plate 17, the dichroic mirror 37, the relay lens system 36, the dichroic mirror 71, a bandpass filter 72, an imaging lens 73, and a scattered light sensor 74. Among the above, the objective lens 2a, the quarter-wave plate 17, the dichroic mirror 37, and the relay lens system 36 are elements common to the UV irradiation device 70a. The scattered light sensor 74 directly detects, as measurement light I3, the excitation light E2 scattered on the surface of the workpiece WO obliquely illuminated by the UV irradiation device 50a of the second photoluminescence detection system 50. Specifically, the scattered light sensor 74 is a TDI sensor, and measures the measurement light I3 with high sensitivity while moving the stage in the Y direction. In the present specification, the observation device 70b is referred to as a dark-field observation device DR, and the scattered light sensor 74 is referred to as a dark-field sensor DS.

The area observation system 91 uses a part of the surface defect detection system 10, and includes a first illumination LED 91a, a polarizing beam splitter prism 91c, a half mirror 91e, a notch filter 91g, an observation dichroic mirror 91i, a bandpass filter 91k, an imaging lens 91m, and a CCD camera 91o. The first illumination LED 91a emits light over a wide band in the visible wavelength region. The first illumination LED 91a is specifically a white LED. By turning on the first illumination LED 91a, observation illumination light L2 is guided to the second lens system 16 and subsequent systems of the surface defect detection system 10 via the polarizing beam splitter prism 91c, the half mirror 91e, the notch filter 91g, and the observation dichroic mirror 91i. At this time, the observation illumination light L2 incident on the workpiece WO includes circularly polarized light by passing through the polarizing beam splitter prism 91c and the quarter-wave plate 17, and is incident on the workpiece WO via the objective lens 2a. The observation illumination light L2 reflected by the workpiece WO travels backward through the surface defect detection system 10 from the objective lens 2a, is taken out of the surface defect detection system 10 by the observation dichroic mirror 91i, is reflected by the half mirror 91e and the polarizing beam splitter prism 91c, and is incident on the CCD camera 91o through the imaging lens 91m and the like. An image captured by the CCD camera 91o with the first illumination LED 91a turned on corresponds to normal microscopic observation. At this time, by switching the bandpass filter 91k to a bandpass filter with a different transmission wavelength, an observation image at a desired wavelength can be acquired.

By turning off the first illumination LED 91a of the area observation system 91 and turning on the excitation laser light source device 31 of the first photoluminescence detection system 30, a fluorescence microscope observation of direct incidence type can be performed. Further, by turning off the first illumination LED 91a and turning on the dual-purpose laser light source device 51 of the second photoluminescence detection system 50, a fluorescence microscope observation of oblique incidence type can be performed.

The autofocus system 93 uses a part of the surface defect detection system 10, and includes a second illumination LED 93a, a bandpass filter 93r, a stripe pattern mask 93s, a polarizing beam splitter prism 93c, an imaging lens 93m, the half mirror 91e, the observation dichroic mirror 91i, a half mirror 93j, a first CCD sensor 93p, and a second CCD sensor 93q. The second illumination LED 93a emits light over a wide band in the visible wavelength region. The second illumination LED 93a is specifically a white LED. The bandpass filter 93r can be switched to one having a desired transmission wavelength characteristic by a turret incorporating a large number of bandpass filters, and a wavelength of AF light L3 for monitoring, that is, an illumination wavelength for AF can be made to correspond to a wavelength during observation or measurement. The stripe pattern mask 93s is for projecting a stripe pattern on the surface of the workpiece WO. The stripe pattern projected on the surface of the workpiece WO is sharp, which means an in-focus state.

The stripe pattern on the workpiece WO is projected onto the first CCD sensor 93p and the second CCD sensor 93q by the objective lens 2a, the second lens system 16, the imaging lens 93m, and the like. The CCD sensors 93p and 93q are image sensors whose operations are controlled by an AF control circuit 7b. The AF control circuit 7b can determine whether the objective lens 2a is in an in-focus state, a front focus state, or a rear focus state based on a contrast of images detected by the CCD sensors 93p and 93q, and can output such a focus state or a shift state to the control device 8. The first CCD sensor 93p is disposed in a state of being shifted forward with respect to the in-focus state, and the second CCD sensor 93q is disposed in a state of being shifted rearward with respect to the in-focus state. Therefore, the in-focus state can be achieved by moving the objective lens 2a in a vertical Z direction by a lens stage 5, and stop lifting the objective lens 2a at a position where a contrast of a pattern detected by the first CCD sensor 93p and a contrast of a pattern detected by the second CCD sensor 93q coincide with each other.

The adjustment of the in-focus state by the autofocus system 93 is not limited to the state on the surface of the workpiece WO, and can be shifted in a depth direction of the workpiece WO. For example, in the measurement of the fluorescence P1, P2, and P3, an interior of the workpiece WO can be focused. For example, by shifting the objective lens 2a to a position offset from detection results of the CCD sensors 93p and 93q, which are image sensors, the interior of the workpiece WO can be focused.

A drive circuit 6a is provided in association with the surface defect detection system 10. The drive circuit 6a operates under the control of the control device 8, and stores a detection result by the reflection sensor 23 while causing the illumination laser light source device 11 to perform vertically incident illumination on the workpiece WO.

A light source drive circuit 6b and a sensor drive circuit 6c are provided in association with the first photoluminescence detection system 30. The light source drive circuit 6b operates under the control of the control device 8, and causes the excitation laser light source device 31 to perform vertically incident optical excitation on the workpiece WO. The sensor drive circuit 6c operates under the control of the control device 8 and stores detection results by the fluorescence sensors 45, 46, and 47.

A light source drive circuit 6d is provided in association with the second photoluminescence detection system 50. The light source drive circuit 6d operates under the control of the control device 8, and causes the dual-purpose laser light source device 51 to perform obliquely incident optical excitation on the workpiece WO. It should be noted that the fluorescence generated by the obliquely incident optical excitation is detected by the fluorescence sensors 45, 46, and 47, and the sensor drive circuit 6c stores the detection results by the fluorescence sensors 45, 46, and 47.

A sensor drive circuit 6e is provided in association with the surface roughness detection system 70. The sensor drive circuit 6e operates under the control of the control device 8, and detects the scattered light from the workpiece WO illuminated by the oblique incidence light, using the scattered light sensor 74. The obliquely incident illumination is performed by the dual-purpose laser light source device 51 driven by the light source drive circuit 6d.

A camera drive circuit 7a is provided in association with the area observation system 91. The camera drive circuit 7a operates under the control of the control device 8, and causes the CCD camera 91o to acquire an area image of the workpiece WO and record the area image while causing the first illumination LED 91a to emit illumination light.

An AF control circuit 7b is provided in association with the autofocus system 93. The AF control circuit 7b operates under the control of the control device 8, and determines a contrast state of the images acquired by the CCD sensors 93p and 93q while causing the second illumination LED 93a to emit AF light.

The objective lens 2a is supported by the lens stage 5 and is movable in the vertical Z direction. The operation of the lens stage 5 is controlled by a lens driving device 5a, and under the control of the control device 8, the objective lens 2a is slightly moved in the Z direction to adjust a focus state of an image detected by the reflection sensor 23.

The stage 4 can support the workpiece WO, move the workpiece WO in an XY direction and the Z direction, and rotate the workpiece WO around an X axis, a Y axis, and a Z axis. The operation of the stage 4 is controlled by a stage controller 4a, and under the control of the control device 8, the workpiece WO can be precisely moved to a predetermined position, and the workpiece WO can be moved at a desired speed along a predetermined path.

In the above, (1) optical elements (including light sources and sensors; the same applies below) constituting the illumination device 10a and the reflection observation device 10b of the surface defect detection system 10, (2) optical elements constituting the UV irradiation device 30a and the fluorescence observation device 30b of the first photoluminescence detection system 30, (3) optical elements constituting the UV irradiation device 50a and the fluorescence observation device 50b of the second photoluminescence detection system 50, (4) optical elements constituting the UV irradiation device 70a and the observation device 70b of the surface roughness detection system 70, (5) optical elements constituting the area observation system 91, and (6) optical elements constituting the autofocus system 93 constitute a common optical path-type optical system 102 as a whole. In the common optical path-type optical system 102, in particular, the objective lens 2a is used for all of the surface defect detection system 10, the first photoluminescence detection system 30, the second photoluminescence detection system 50, the surface roughness detection system 70, the area observation system 91, and the autofocus system 93. The common optical path-type optical system 102 that performs irradiation with the illumination light I1 and irradiation with the excitation light E1 in parallel can simultaneously measure the directly reflected measurement light I2 and the fluorescence P1, P2, and P3 due to excitation, thereby improving an inspection speed. In addition, since the objective lens 2a is common to the surface defect detection system 10, the photoluminescence detection systems 30 and 50, and the surface roughness detection system 70, the autofocus system 93 can be easily shared among the surface defect detection system 10, the photoluminescence detection systems 30 and 50, and the surface roughness detection system 70, and the measurement can be performed with high accuracy.

The control device 8 is a computer, includes an arithmetic processing device, a storage device, a communication device, and the like, and operates according to a program or an instruction of an operator.

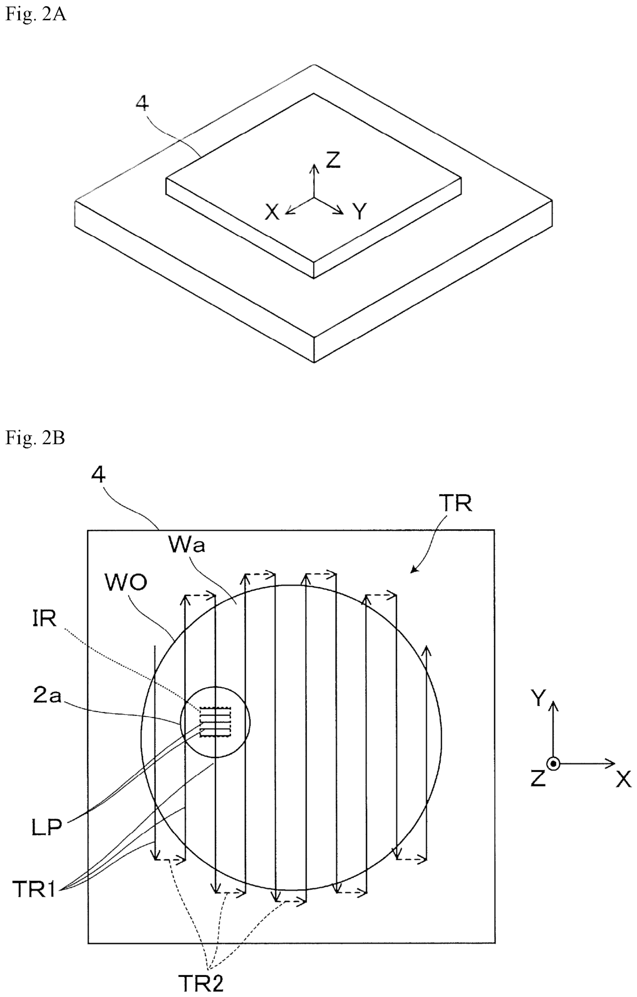

Fig. 2A illustrates coordinate axes on the stage 4, and Fig. 2B illustrates relative movement of the objective lens 2a and the like with respect to the stage 4 and the workpiece WO. In this case, the Y direction is a main scanning direction, and the X direction is a sub-scanning direction. An inspection region IR is formed immediately below the objective lens 2a. The objective lens 2a or the inspection region IR moves stepwise along a trajectory TR. A multi-line pattern LP is projected onto the inspection region IR. The trajectory TR includes a main scanning trajectory TR1 indicated by a solid line and a sub-scanning trajectory TR2 indicated by a dotted line. As a result, the inspection region IR moves to cover an entire surface Wa of the workpiece WO.

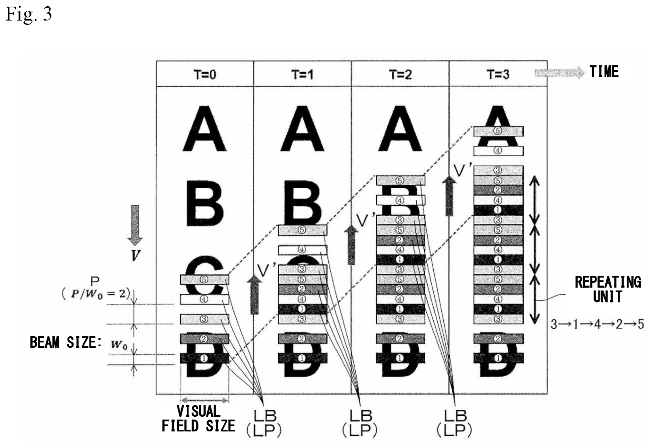

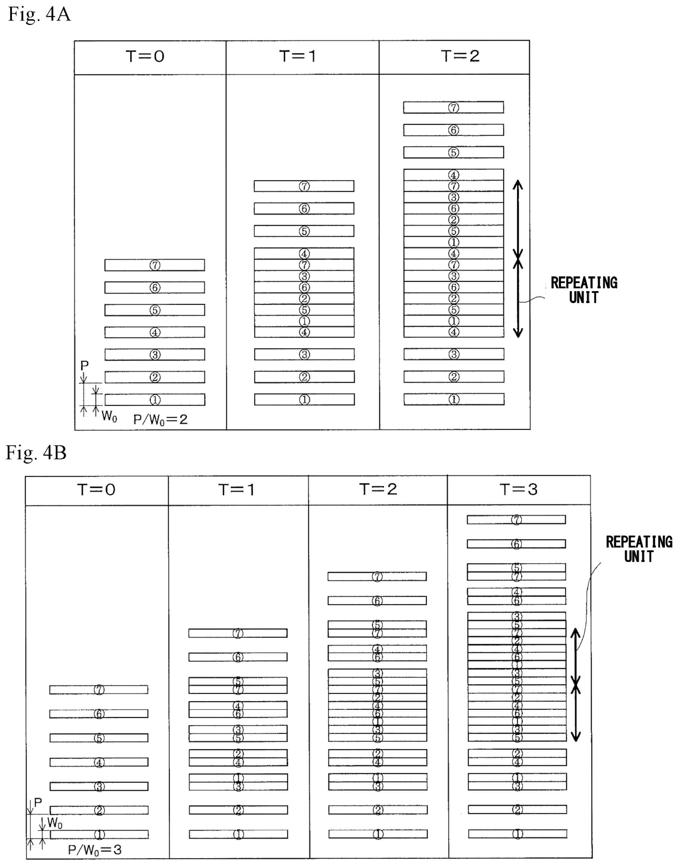

Fig. 3 illustrates an example of an image acquisition method using multiple beams including a large number of line beams LB. In the figure, four blocks indicate an elapse of one frame period (T = 0, 1, 2, 3), and patterns (A, B, C, D) in each block indicate virtual patterns formed on the workpiece WO. An arrow V indicates movement of the stage 4 or the workpiece (see Fig. 2B), and an arrow V' indicates relative movement of a line beam. In this case, assuming that $P/W_0 = 2$ and $n = 2$ (the number of beams is 5), the line beam LB is moved by $W_O \times 5$ in one step. Here, the value P indicates a beam pitch, the value $W_0$ indicates a beam size, and the value n indicates any positive number. In the illustrated example, it is necessary to rearrange detection results of the five line beams LB in a memory in the order of 3rd → 1st → 4th → 2nd → 5th, and detection results of two line beams LB at the beginning and end of the scanning are discarded, but it is possible to continuously acquire and reconstruct the pattern on the workpiece WO while moving the workpiece WO at a constant speed. For example, as illustrated in Fig. 4A, assuming that $P/W_0 = 2$ and $n = 3$ (the number of beams is 7), the line beam LB may be moved by $W_O \times 7$ in one step. In this case, detection results of the seven line beams LB are rearranged in the memory in the order of 4th → 1st → 5th → 2nd → 6th → 3rd → 7th. $P/W_0$ is not limited to 2 and may be 3 or more. Specifically, for example, as illustrated in Fig. 4B, assuming that $P/W_0 = 3$ and $n = 2$ (the number of beams is 7), the line beam LB may be moved by $W_O \times 7$ in one step. In this case, detection results of the seven line beams LB are rearranged in the memory in the order of 5th → 3rd → 1st → 6th → 4th → 2nd → 7th. As is clear from the above, the second multi-beam or line beam group is arranged next to the (n+1)th line beam LB in the first multi-beam. In general, the number N of beams included in multiple beams is given by $N = n \times (P/W_0) + 1$, and a stage velocity v is given by $v = W_O \times N/T$.

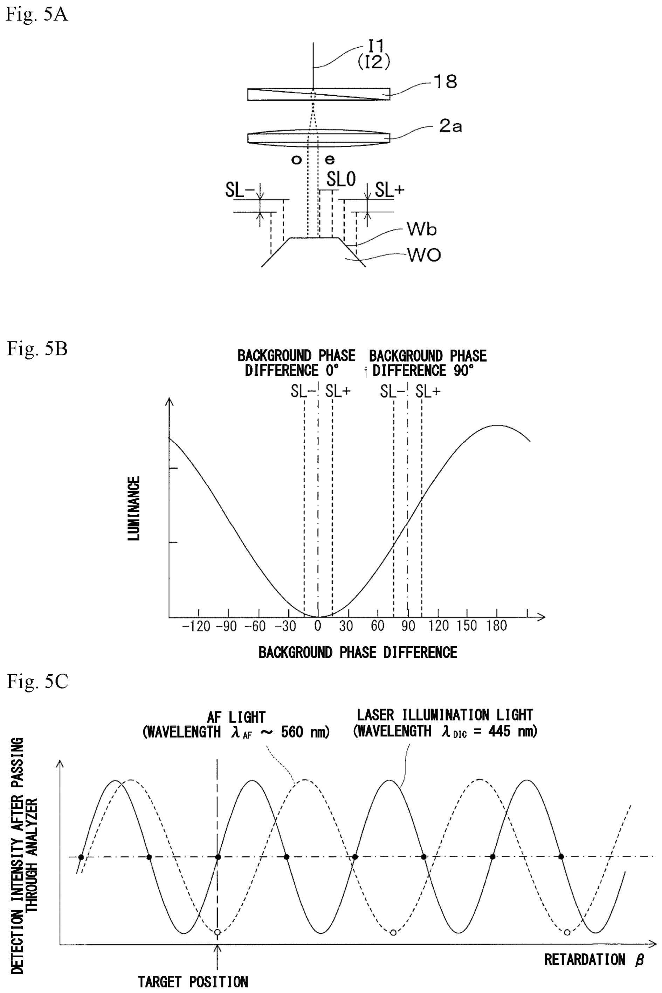

Figs. 5A to 5C are diagrams illustrating a method of avoiding malfunction of an AF operation by the autofocus system 93 due to stray light components generated in various optical elements during surface inspection by the surface defect detection system 10. Fig. 5A illustrates a function of the Nomarski prism 18, in which a polarization component of the laser illumination light I1 is separated into two components such as ordinary light and extraordinary light, and the ordinary light and the extraordinary light are incident on, for example, two points separated from each other in the Y direction on the workpiece WO, and the measurement light I2 reflected by the workpiece WO passes through the Nomarski prism 18 again and travels backward along the same optical path. At this time, in a protrusion Wb, inclinations SL+ and SL- are present on one slope and the other slope. Fig. 5B illustrates an influence of the inclinations SL+ and SL- on a luminance contrast, and when a background phase (that is, retardation) of the Nomarski prism 18 is set to 90 degrees, the luminance contrast increases in accordance with the inclination SL+ and becomes brighter, and decreases in accordance with the inclination SL- and becomes darker, so that the two types of inclinations SL+ and SL- can be distinguished. Fig. 5C is a conceptual diagram illustrating a detection intensity of the laser illumination light I1 and a detection intensity of the AF light by the autofocus system 93 during differential interference measurement on the surface of the workpiece WO by the surface defect detection system 10, and the horizontal axis indicates retardation β by the Nomarski prism 18. In the specific example, an illumination wavelength of the laser illumination light I1 is $\lambda_{DIC}$ = 445 nm, and a wavelength of the AF light is $\lambda_{AF}$ ~ 560 nm. During the differential interference measurement, the laser illumination light I1 is desirably detected in a state such as a black circle (•) (maximum inclination state). Accordingly, the inclination that is a change in light intensity becomes maximum, the sensitivity becomes highest, and it becomes easy to determine the protrusion Wb, that is, to determine irregularities of a defect shape. On the other hand, the AF light is desirably detected in a state (minimum state) such as a white circle (o). In this case, the AF light traveling toward the workpiece WO is incident on the Nomarski prism 18 as, for example, right-handed circularly polarized light, and the AF light reflected by the workpiece WO is emitted from the Nomarski prism 18 as, for example, left-handed circularly polarized light, resulting in an orthogonal state. Therefore, it is possible to prevent the first CCD sensor 93p and the second CCD sensor 93q of the autofocus system 93 from detecting the AF light and stray light in a wavelength region thereof after being cut by the polarizing beam splitter prism 93c. In particular, when the workpiece WO is a SiC wafer, the SiC wafer is nearly transparent in the visible wavelength region (reflectance of about 10%) and the reflected light intensity is small. It is important to increase an optical S/N ratio by removing stray light components generated in all optical elements. That is, by setting the retardation β by the Nomarski prism 18 at a target position where the laser illumination light I1 is in the maximum inclination state indicated by the black circle and the AF light is in the minimum state indicated by the white circle, it is possible to prevent the influence of the stray light on the AF operation during the differential interference measurement. The retardation β has the following relationship.

$$\beta = \beta_0 + x\frac{d\beta}{dx}$$

$$\frac{d\beta}{dx} = \pm\frac{8\pi}{\lambda}(n_e - n_o)\tan\theta_w \propto \frac{1}{\lambda}$$

β:retardation, x:prism position, $\beta_0$:initial phase at x=0

λ:wavel ength' $n_0(n_e)$:refractive index of normal light

(abnormal light)' $\theta_w$ wedge angle

When the wavelength $\lambda_{AF}$ of the AF light is an integral multiple of the illumination wavelength $\lambda_{DIC}$/4 of the laser illumination light I1, it is easy to adjust the target position where the laser illumination light I1 is in the maximum inclination state indicated by the black circle and the AF light is in the minimum state indicated by the white circle. The wavelength of the AF light can be adjusted by adjusting transmission characteristics through switching the bandpass filter 93r. The retardation β can be adjusted by shifting the position of the Nomarski prism 18 as described above.

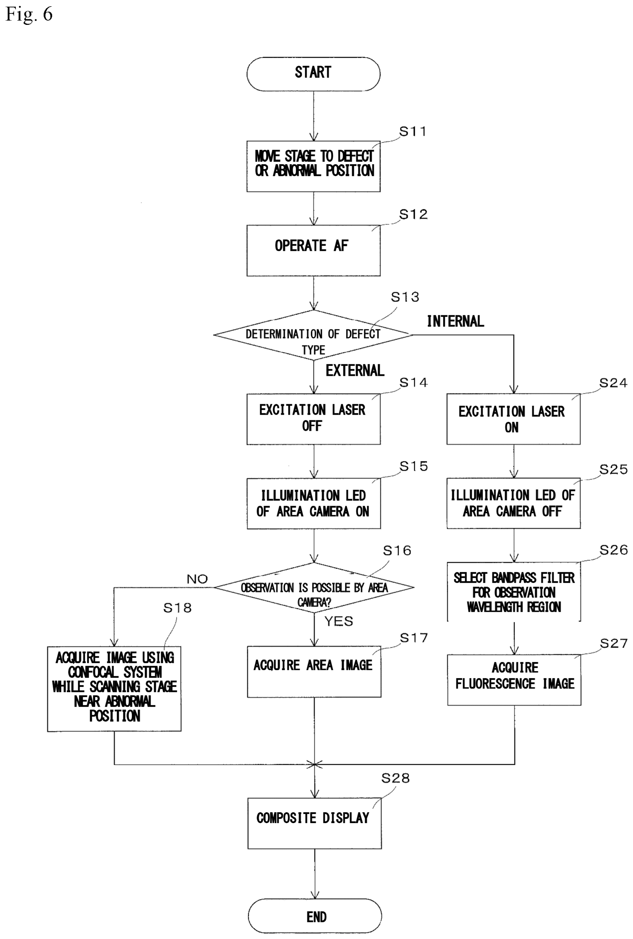

Fig. 6 illustrates a defect review operation. The review operation is performed after the overall inspection of the workpiece WO. In the overall inspection of the workpiece WO, the surface defect detection system 10, the first photoluminescence detection system 30, the second photoluminescence detection system 50, and the surface roughness detection system 70 are simultaneously operated in parallel, and vertically incident illumination-type surface defect information, vertically incident excitation-type fluorescence distribution information, obliquely incident excitation-type fluorescence distribution information, and obliquely incident illumination-type surface roughness information are collectively detected for the entire workpiece WO. Further, in the review operation, it is possible to move to a location where there is an abnormality such as a defect and individually observe the abnormal location.

First, the stage 4 is moved under the control of the control device 8 so that the objective lens 2a faces a defect position or an abnormal position of the workpiece WO (step S11). Next, the autofocus system 93 is operated under the control of the control device 8 to perform the AF operation (step S12). The control device 8 determines the type of the defect or abnormality at this position (step S13).

When the defect or abnormality is on the surface, the operation of the excitation laser light source device 31 is set to OFF (step S14), and the operation of the first illumination LED 91a of the area observation system 91 is set to ON (step S15). The control device 8 determines whether observation by the area observation system 91 is possible (step S16). If the observation by the area observation system 91 is possible (YES in step S16), an area image of the workpiece WO is acquired by the CCD camera 91o of the area observation system 91 (step S17). If the observation by the area observation system 91 is impossible (NO in step S16), the surface defect information is acquired by the surface defect detection system 10 while performing relative scanning of the workpiece WO in a region near the abnormal location (step S18). Accordingly, a defect image at the abnormal location can be acquired and presented to an operator.

When the defect or the abnormality is internal, the operation of the excitation laser light source device 31 is set to ON (step S24), and the operation of the first illumination LED 91a of the area observation system 91 is set to OFF (step S25). The control device 8 selects, based on operator instructions or program specifications, the bandpass filter 48 and the fluorescence sensors 45, 46, and 47 in a wavelength region to be observed (step S26). Thereafter, the control device 8 operates the first photoluminescence detection system 30 and the like to acquire a fluorescence image of the workpiece WO (step S27).

When the defect or the abnormality is on the surface and internal, the control device 8 composites these images and displays the composite image on a display (not illustrated) provided in the control device 8 (step S28). When compositing the images, coloring, area classification, or three-dimensional display can also be performed.

The inspection device 100 of the embodiment described above includes: the surface defect detection system 10 including the illumination device 10a including the illumination laser light source device 11 and the reflection observation device 10b including the reflection sensor 23; and the photoluminescence detection system 30 including the UV irradiation device 50a including the excitation laser light source device 31 and the fluorescence observation device 50b including the fluorescence sensors 45, 46, and 47, in which the measurement light I2 is acquired by the reflection observation device 10b and the fluorescence P1, P2, and P3 are acquired by the fluorescence observation device 50b while irradiating the object OB with the illumination light I1 by the illumination laser light source device 11 and irradiating the object OB with the excitation light E1 by the excitation laser light source device 31.

In the inspection device 100, since the illumination laser light source device 11 and the excitation laser light source device 31 are provided separately, a sensor or an optical system for obtaining a reflection image can be freely selected, and the surface defect detection system 10 can be made highly accurate.

In the inspection device 100, the photoluminescence detection systems 30 and 50 illuminate the object with the excitation light E1 of a plurality of wavelengths. In this case, since a penetration depth of the excitation light E1 into a substrate, which is the object OB or the workpiece WO, depends on the wavelength, it is possible to inspect defects having different depths in the substrate.

The present invention is not limited to the above embodiment, and can be implemented in various modes without departing from the scope of the invention. Those skilled in the art can appropriately make various modifications or changes to the configurations and details of the present invention within the scope of the technical idea of the present invention described in the claims. For example, the workpiece WO to be inspected is not limited to the SiC wafer, and may be another compound semiconductor substrate such as $Ga_2O_3$ or GaN, or a Si wafer.

In the above embodiment, the first fluorescence sensor 45 detects the fluorescence P1 in the infrared wavelength region of 700 nm or more, the second fluorescence sensor 46 detects the fluorescence P2 in the visible wavelength region, and the third fluorescence sensor 47 detects the fluorescence P3 in the near ultraviolet wavelength region of 380 to 400 nm, but two fluorescence sensors can also be used to measure fluorescence in two wavelength regions. In this case, for example, the first fluorescence sensor 45 or the second fluorescence sensor 46 can be omitted.

This application claims the benefit of foreign priority to Japanese Patent Application No. 2023-063355 filed on April 10, 2023, which is incorporated by reference in its entirety.

**Claims**

1. An inspection device comprising:

   a surface defect detection system including an illumination device including an illumination laser light source device and a reflection observation device including a reflection sensor; and
   a photoluminescence detection system including a UV irradiation device including an excitation laser light source device and a fluorescence observation device including a fluorescence sensor, wherein
   measurement light is acquired by the reflection observation device and fluorescence is acquired by the fluorescence observation device while irradiating an object with illumination light by the illumination laser light source device and irradiating the object with excitation light by the excitation laser light source device.

2. The inspection device according to claim 1, further comprising: a common optical path-type optical system configured to perform irradiation with the illumination light by the illumination laser light source device and irradiation with the excitation light by the excitation laser light source device in parallel.

3. The inspection device according to claim 1, wherein in the surface defect detection system, the illumination device and the reflection observation device form a confocal optical system.

4. The inspection device according to claim 1, wherein the surface defect detection system is a multi-beam optical system and composites images obtained by a plurality of line sensors.

5. The inspection device according to claim 1, further comprising:

   an oblique incidence device including an oblique incidence light source device; a dark-field observation device including a dark-field sensor; and a surface roughness detection system, wherein

the oblique incidence device and the surface roughness detection system serve as elements constituting the common optical path-type optical system together with the surface defect detection system and the photoluminescence detection system.

6. The inspection device according to claim 5, wherein the illumination device, the reflection observation device, the UV irradiation device, the fluorescence observation device, the oblique incidence device, and the dark-field observation device have a common objective lens as the common optical path-type optical system.

7. The inspection device according to claim 1, wherein the photoluminescence detection system illuminates the object with excitation light of a plurality of wavelengths.

8. The inspection device according to claim 1, wherein the photoluminescence detection system measures fluorescence from the object in a plurality of wavelength regions including a near ultraviolet wavelength region and a long wavelength region having a longer wavelength than the near ultraviolet wavelength region.

Fig. 1

EP 4 697 014 A1

Fig. 2A

Fig. 2B

Fig. 3

Fig. 4A

Fig. 4B

Fig. 5A

Fig. 5B

BACKGROUND PHASE DIFFERENCE

Fig. 5C

Fig. 6

## INTERNATIONAL SEARCH REPORT

| | |
|---|---|
| International application No. | |
| | **PCT/JP2024/007268** |

**A. CLASSIFICATION OF SUBJECT MATTER**

***G01N 21/956***(2006.01)i; ***G01N 21/88***(2006.01)i; ***H01L 21/66***(2006.01)i
FI:  G01N21/956 A; G01N21/88 K; H01L21/66 J

According to International Patent Classification (IPC) or to both national classification and IPC

**B. FIELDS SEARCHED**

Minimum documentation searched (classification system followed by classification symbols)

G01N21/84-G01N21/958; G01N21/62-G01N21/74; H01L21/66; G01B11/00-G01B11/30

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | CN 114235836 A (SHENZHEN ONE-FOLD SCIENCE AND TECHNOLOGY LIMITED COMPANY) 25 March 2022 (2022-03-25)<br>paragraphs [0001]-[0004], [0032]-[0064], fig. 1 | 1-8 |
| Y | JP 2015-119056 A (LASERTEC CORP.) 25 June 2015 (2015-06-25)<br>paragraphs [0010], [0023], [0025]-[0036], fig. 1 | 1-8 |
| Y | US 2019/0302025 A1 (ETAMAX CO., LTD.) 03 October 2019 (2019-10-03)<br>paragraphs [0032]-[0034], fig. 4 | 1-8 |
| Y | JP 2003-4654 A (LASERTEC CORP.) 08 January 2003 (2003-01-08)<br>paragraphs [0011], [0015]-[0018], fig. 4, 5 | 3-4 |
| A | US 2020/0365685 A1 (CREE, INC.) 19 November 2020 (2020-11-19)<br>entire text, all drawings | 1-8 |
| A | JP 61-088107 A (HEIDELBERG INSTRUMENTS GMBH) 06 May 1986 (1986-05-06)<br>entire text, all drawings | 1-8 |

☐ Further documents are listed in the continuation of Box C.  ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **15 April 2024** | **07 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/007268**

| Patent document cited in search report | | | Publication date (day/month/year) | Patent family member(s) | | | Publication date (day/month/year) |
|---|---|---|---|---|---|---|---|
| CN | 114235836 | A | 25 March 2022 | (Family: none) | | | |
| JP | 2015-119056 | A | 25 June 2015 | US<br>paragraphs [0013], [0027],<br>[0037]-[0050], fig. 1<br>JP | 2015/0168311<br><br><br>5633099 | A1<br><br><br>B1 | |
| US | 2019/0302025 | A1 | 03 October 2019 | WO<br>CN<br>KR | 2018/117440<br>210294061<br>10-1810078 | A1<br>U<br>B1 | |
| JP | 2003-4654 | A | 08 January 2003 | (Family: none) | | | |
| US | 2020/0365685 | A1 | 19 November 2020 | WO | 2020/236448 | A1 | |
| JP | 61-088107 | A | 06 May 1986 | US<br>entire text, all drawings<br>EP<br>DE | 4732473<br><br>168643<br>3422143 | A<br><br>A2<br>A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5633099 B
- JP 5713419 B

- JP 2023063355 A